# EUROPEAN PATENT APPLICATION

(11) **EP 0 653 819 A2**
(43) Date of publication of application: **17.05.1995**
(21) Application number: 95200174.1
(22) Date of filing: 04.11.1991
(51) Int. Cl.: H01R 23/68

(54) **High density electrical connector**

(30) Priority: 08.11.1990 US 610619; 08.11.1990 US 610871
(62) Divisional of application: 91310149.9
(71) Applicant: THE WHITAKER CORPORATION, Wilmington, Delaware 19808 (US)
(72) Inventor: Goetzinger, David Joseph, Camp Hill Pennsylvania 17011 (US); Deak, Frederick Robert, Kernersville, North Carolina 27284 (US); Casciotti, Albert, Hershey, Pennsylvania 17033 (US); Wrisley Jr.,David Burr, Greensboro, North Carolina 27410 (US)
(74) Representative: Warren, Keith Stanley

(57) **Abstract**

An electrical connector (339) for electrically interconnecting circuits on electrical circuit boards (310,330) includes a pair of tubes (350) spaced apart to receive a daughter board (310) therebetween. Coil springs (340) in grooves (354) on adjacent tube surfaces provide a normal force against circuits on a film strip (320) covering the spring (340). Fluid is passed through the tubes (350) via pipes (364) to heat or cool the coil springs (340) which are made from a shaped memory metal alloy material.

## Description

The present invention relates to electrical connectors for interconnecting circuits of the type carried in printed circuit boards wherein such circuits are on close center-to-center spacings to provide high density electronic packaging.

The trend in electronic packaging with respect to the interconnection of circuits has been one of constantly increasing density, reduced center-to-center spacing, and smaller components. Thus, center line spacing has dropped from 0.254 to 0.127 cm (0.200 to 0.050 inches) with current trends pushing toward less than 0.0254 cm (0.010 inches) for traces on printed circuit boards and contact pad centers on the order of less than 0.0508 cm (0.020 inches). With this trend, the difficulty of forming metal parts such as contact springs which provide sufficient forces of engagement of contacts to assure stable low resistance interfaces has led to difficulty in manufacture and assembly, difficulty in maintaining alignment of small parts and in mounting such parts in plastic housings. High density also leads to high cumulative contact forces which must be maintained to provide contact integrity.

US-A-4 060 824 addresses the foregoing trends by the use of a flexible printed circuit film strip which has contact pads and an assembly, including housings which have grooves along the surfaces thereof facing the printed circuit boards to contain elongated coil springs which press the film strips and their contact pads against the contact pads on the printed circuit boards to provide an interconnection.

With high density connectors of the type being discussed, where there are dozens, if not hundreds, of contact pads, circuit board insertion and extraction can be difficult with possible damage to the contacts or components carried on such boards.

Accordingly, it is an object of the present invention to provide a low force electrical connector for high density electrical interconnection applications which can be operated between two conditions, a low force engagement and a high force engagement. It is a further object to provide a low cost means effective to cause interconnections of contact pads on close centers by individual spring members responsive to temperature variations to effect forces for insertion, withdrawal, and mating contact. It is yet a further object to provide a novel interconnection medium capable of providing in one piece large numbers of individual force vectors along the linear length thereof which can be varied in response to selected temperature changes.

The present invention consists in electrical connector as defined in claim 1.

A connector according to the preamble of claim 1 is disclosed in US-A-4 934 942.

An embodiment of the present invention will now be described by way of example with reference to the accompanying drawings, in which:
Figure 1 is a perspective view of an electrical connector mounted on a mother board and preparatory to receiving a daughter board for interconnection therewith;
Figure 2 is an enlarged sectional view including phantom representations of spring action of the connector shown in Figure 1; and
Figure 3 is a schematic view of a manifolding system for use in conjunction with the connector.

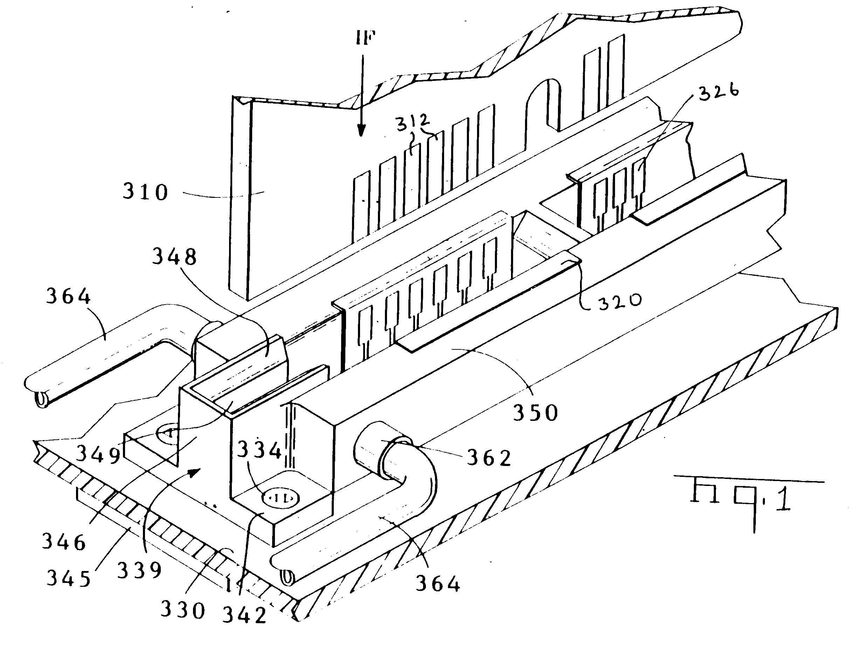

As shown in Figure 1, an assembly of a daughter board 310, a mother board 330 via a connector 339 is shown with the daughter board 310 preparatory to insertion with connector 339.

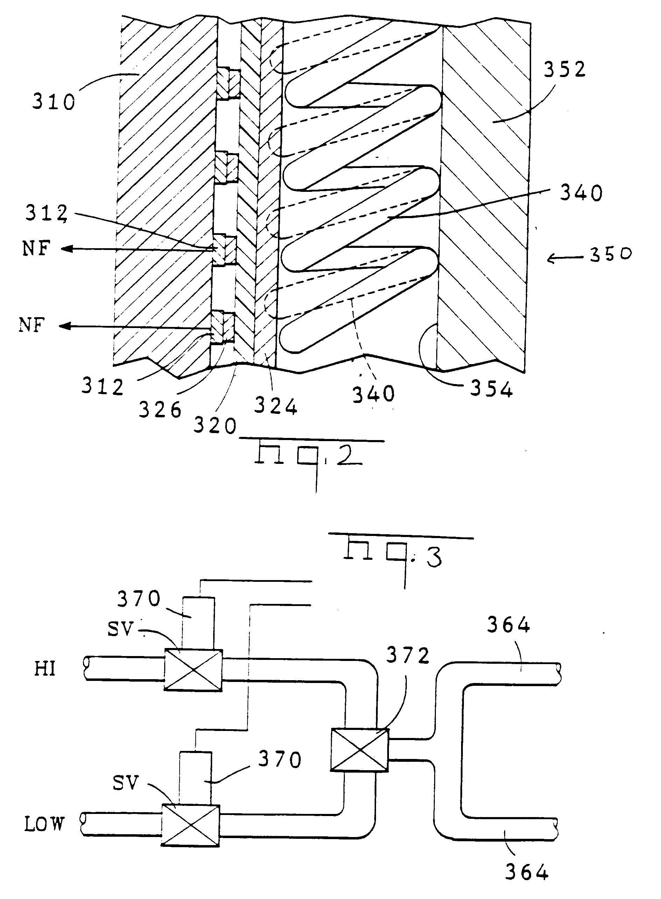

The connector 339 is fabricated of a suitable material such as high strength zinc alloy to include as shown in Figure 1 at the near end a pair of flanges 342 through which are passed fasteners 334 which extend through board 330 and join a metal plate element 345 beneath the board to lock the connector thereto. Connector 339 has at each end, the near end being shown, the far end being unshown, a board guide structure 346 bevelled at the top as at 348 and slotted as at 349 to receive the edge card 310 and hold such edge in position, a similar structure at the other end not shown holding the other end edge of card 310. Integral with the guide structure 346 are connector body tubular elements 350 spaced apart and formed of metal to be rigid and nonyielding transverse to the length thereof for purposes to be described. The connector body elements 350 are in fact hollow as indicated in Figure 2 and include relatively thick wall sections 352 which, on two surfaces have grooves 354.

As is indicated in Figure 1, the board 310, and thus its contact paths, is inserted into the connector 339 to effect an interconnection and is withdrawn therefrom to effect a disconnection.

Coil springs 340 in the connector elements 350 (Figure 2) are made of shape memory alloy material. Such alloys can be selected from materials to provide dramatic changes in those characteristics such as Youngs Modulus or Shear Modulus and elongation over a range of transition temperatures. Alloys being commercially used include CuZnAl, CuAl and NiTi. The June 1984 issue of Mechanical Engineering includes an article entitled "Shaped Memory Metals" which details appropriate characteristics and refers to a number of sources for such metals. A further source for shape memory metals includes Memory Corporation of Norwalk, Connecticut. As related in said article, alloys may be chosen which exhibit a transformation characteristic at different temperatures. Below a given transformation or phasing temperature, an alloy may exhibit a weak or Martensitic condition so as to facilitate a relatively low force per unit of deflection characteristic and above such temperature the alloy may revert to a parent beta phase or the Austenitic state exhibiting an increase in modulus. Quite the reverse characteristic may be obtained with still further alloys wherein at the higher range of temperature, above the transformation temperature,e the alloy is relatively weak and below that temperature it is relatively strong.

In accordance with this embodiment, it is contemplated to use a spring 340 of shape memory alloy having a transformation temperature to a weak state at or around 4.444°C (40 degrees Fahrenheit). Springs 340 fabricated with such an alloy material and held below 4.444°C (40 degrees Fahrenheit) will therefore have the weak characteristic and above such transition temperature revert to the high force characteristic.

In Figure 2 a spring 340 is shown disposed within one connector body element 350 resting within the groove 354 proximate to pads 326 on film strip 320 covering the spring 340, and pads 312 on the daughter board. Figure 2 shows the spring 340 solidly representing the weak state and in phantom as at 340' representing the strong condition. As can be discerned, the individual coils push against thin metal foil 324 proximate to the contact interfaces between pads 312 and 326. The normal forces resulting therefrom, NF, create and maintain a low resistance stable interface. The temperature of the springs 340 is maintained by conductive heat transfer through the metallic wall sections 352 to the springs 340 themselves which are in contact with such wall sections, the film strip 320 insulating electrically. Within the elements 350 is a heating/cooling medium which can be made to vary in temperature from of the order of 35 degrees Fahrenheit or less to of the order of 75 degrees Fahrenheit or greater. The medium is introduced into the interiors of each connector body element 350 through a fitting as at 362 in Figure 1 and a pipe as at 364 as shown in Figure 1. Fittings and pipes at the opposite end of the connector bodies, not shown, would remove such medium. Figure 3 shows a manifold system comprising a series of pipes, including a source of high temperature medium and a source of low temperature medium, each valved by solenoid valves SV under controls 370 to be mixed at a valve 372 and transferred to the connector body elements 350 via pipes 364. The returns for such medium are not shown. In this way, a connector body element 350 may be cooled (or heated as the case might be) to allow the insertion or withdrawal of board 310 with minimum normal forces, an LIF characteristic, or a ZIF connector using the retraction of the spring in its weak condition. Thereafter, upon reinsertion of a board 310 the medium can be introduced into the connector body elements 350 to heat (or cool) the springs and cause the strong, expanded condition to occur, thus generating adequate normal forces for each of the multiple contacts of the system. The average length of time generally required is a few seconds or minutes at the most. The manifold system may employ gases; e.g. Freon, air, CO₂, liquid nitrogen, and liquid; e.g. ethyleneglycol, water and so forth.

Use is made in this embodiment of shape memory alloy springs in conjunction with printed circuit board and film contacts and a source of heat and/or cooling with the springs being made of a shape memory alloy material. The springs 340, utilised to establish contact forces with the mother board, may be of a standard ca2-13nted coil spring steel in that such contacts are rarely made and broken and would, in any event, be brought into engagement by the clamping of the connector 339 through the holding portions thereof into engagement with the mother board 310.

## Claims

1. An electrical connector (339) comprising a pair of parallel tubes (350), having grooves (354) in adjacent sides with coil springs (340) in said grooves (354) and a flexible, circuit-carrying film strip (320) covering the springs (340), wherein each tube (350) includes a passage therethrough; characterised in that the passage is sealed at each end and is provided with fluid fittings (362) and pipes (364) for a heating or cooling medium.

2. A connector as claimed in claim 1, characterised in that the coil springs (340) are made from a shaped memory alloy material reactive to the temperature of fluid moving through the passages.

3. A connector as claimed in claim 1 or 2, characterised in that a thin foil (324) of metal is provided between the springs (340) and the film strip (320).
